Europäisches Patentamt

European Patent Office

Office européen des brevets

(19)

(11) EP 1 067 642 A1

(12) ## DEMANDE DE BREVET EUROPEEN

(43) Date de publication:
      10.01.2001   Bulletin 2001/02

(51) Int Cl.7: **H01S 5/028**, G02B 1/10,
      G02B 5/28, H01L 31/00

(21) Numéro de dépôt: 00401958.4

(22) Date de dépôt: 06.07.2000

(84) Etats contractants désignés:
      **AT BE CH CY DE DK ES FI FR GB GR IE IT LI LU
      MC NL PT SE**
      Etats d'extension désignés:
      **AL LT LV MK RO SI**

(30) Priorité: **08.07.1999  FR 9908879**

(71) Demandeur: **ALCATEL**
      **75008 Paris (FR)**

(72) Inventeurs:
      • **Olivier-Martin, François**
        **94230 Cachan (FR)**
      • **Courant, Jean-Luc**
        **94230 Cachan (FR)**
      • **Medjdoub, Mokhtaria**
        **94230 Cachan (FR)**

(74) Mandataire: **Ballot, Paul**
      **Cabinet Ballot-Schmit,**
      **16, Avenue du Pont Royal**
      **94250 Cachan (FR)**

(54) **Composant optoélectronique comportant un empilement de Bragg.**

(57)    L'invention concerne un composant optique sur matériau semi-conducteur comportant au moins un empilement de Bragg comprenant une succession de couches d'indices différents, caractérisé en ce que lesdites couches sont réalisées dans un matériau amorphe composé d'au moins deux éléments prédéterminés, la différence d'indice entre les couches successives étant obtenue par des rapports stoechiométriques différents desdits éléments.

EP 1 067 642 A1

## Description

La présente invention se situe dans le domaine général de l'optoélectronique, et concerne plus précisément un composant optique avec un empilement de Bragg réalisé sur un substrat semi-conducteur tel que de l'InP, par exemple.

La loi de Bragg définit les conditions de transmission ou de réflexion d'un signal lumineux par un composant en fonction du revêtement déposé sur la surface du composant. Pour obtenir un minimum de réflexion, cette loi s'exprime par la relation suivante :

$$n * e = \lambda / 4$$

où

n($\lambda$) est l'indice de réfraction du revêtement ;
e est l'épaisseur du revêtement ;
$\lambda$ est la longueur d'onde du signal transmis par le composant.

Ainsi, pour une longueur d'onde $\lambda$ donnée, l'indice et l'épaisseur du revêtement déterminent la nature réfléchissante ou anti-réfléchissante de la surface du composant.

Une couche unique de revêtement permet un contrôle du pouvoir réfléchissant pour une longueur d'onde donnée. La réalisation d'un empilement de Bragg, composé d'une pluralité de paires de couches de revêtement, permet d'élargir le spectre, ainsi que le pouvoir de réflexion ou de transmission du composant.

Le dépôt d'un miroir de Bragg en extrémité d'un composant est couramment réalisé sur les composants optoélectroniques. Un tel miroir est généralement constitué d'un empilement de paires de couches distinctes dont les indices de réfraction respectifs sont très différents.

Un tel miroir de Bragg, peut être réalisé à l'extrémité d'un composant, tel qu'un laser par exemple, afin de permettre une réflexion optimale de la lumière par ledit composant. Le pouvoir réfléchissant d'un miroir de Bragg peut atteindre les 99.99 %, valeur impossible à atteindre avec une seule couche de revêtement.

En particulier, pour un laser à émission par la surface (VCSEL, Vertical Cavity Surface Emitting Laser, en terminologie anglaise), la réalisation d'un empilement de Bragg sur la surface est primordiale.

De même, un empilement de Bragg peut être réalisé sur une photo-diode par exemple, afin de constituer une couche anti-réfléchissante pour améliorer la sensibilité du composant.

L'invention s'applique également à tout type de composant optique pouvant nécessiter une grande différence d'indice, tel qu'un guide d'onde, un coupleur ou autre.

Les techniques les plus connues pour déposer un tel empilement de Bragg sont le dépôt de matériaux amorphes ou polycristallins, par pulvérisation réactive ou non, ou par un canon à électrons, et la croissance par épitaxie d'un matériau semi-conducteur.

La première méthode de dépôt d'un empilement de Bragg exploite la technique connue du canon à électrons ou de pulvérisation réactive à partir de deux sources distinctes.

Les matériaux utilisés dans cette méthode proviennent de deux sources distinctes et sont des matériaux amorphes présentant une grande différence d'indice de réfraction et un faible pouvoir réfléchissant. Un faisceau d'électrons est envoyé sur une source afin de déposer une couche de matériau sur un échantillon du composant situé à une distance donnée.

Ainsi, on obtient des miroirs de Bragg composés d'une succession de couches, par exemple de Silice et d'Oxyde de titane ($SiO_2/TiO_2$), ou de Silice et de Silicium ($SiO_2/Si$) . Pour une longueur d'onde de 1.5 $\mu$m, les indices de réfraction respectifs de telles couches sont de 1.46 et 2.23 et de 1.46 et 3.6.

Cette technique de dépôt bi-sources est souvent utilisée avec de bons résultats. Il s'agit néanmoins d'une technique longue et lourde à mettre en oeuvre. Il faut en effet prévoir deux sources distinctes pour les deux matériaux composant les couches successives de l'empilement de Bragg, et réaliser ainsi les couches l'une après l'autre en ouvrant et fermant alternativement une source après l'autre.

La deuxième méthode de dépôt d'un empilement de Bragg est réalisée sur un substrat cristallin et exploite une technique de croissance par épitaxie d'une succession de couches cristallines fines de différents indices de réfraction. Les méthodes les plus connues de croissance par épitaxie sont « l'épitaxie en phase vapeur » (VPE pour Vapor Phase Epitaxy, en terminologie anglaise) et « l'épitaxie par jet de molécules » (MBE pour Molecular Beam Epitaxy en anglais).

En particulier les techniques connues sous les termes de MOVPE (Metal Organic Vapor Phase Epitaxy, en terminologie anglaise) et de MOCVD (Metal Organic Chemical Vapor Deposition en anglais) sont couramment utilisées car elles se prêtent bien à des procédés industriels et permettent d'obtenir des couches très fines. Ces techniques désignent respectivement l'utilisation de la VPE et de la MBE avec des métaux organiques comme supports des précurseurs de l'épitaxie.

Avec la MOVPE, par exemple, les différents matériaux qui doivent participer à la croissance sont apportés dans un réacteur par des précurseurs mis sous forme de vapeur pour interagir à la surface du composant et faire croître une couche d'un matériau donné.

Ainsi, on obtient des successions de couches fines de différents indices de réfraction, comme par exemple sur un substrat d'Arséniure de Gallium, une alternance d'Arséniure de Gallium et d'Arséniure d'Aluminium (GaAs/AlAs), ou par exemple sur un substrat de Phosphure d'Indium, de l'Antimoine d'Arséniure de Gallium Aluminium et de l'Antimoine d'Arséniure d'Aluminium (AlGaAsSb/AlAsSb). Pour une longueur d'onde de 1.5 μm, les indices de réfraction respectifs de telles couches sont de 3.372 et 2.9 et de 3.65 et 3.11.

Ces techniques sont également couramment utilisées avec de bons résultats. Néanmoins, les conditions opératoires sont lourdes et le procédé de croissance est long et difficile à maîtriser.

De plus, les différentes méthodes décrites de réalisation d'un empilement de Bragg sur un composant nécessitent l'utilisation de deux matériaux distincts intervenant successivement et alternativement dans le procédé.

Il est alors nécessaire de prévoir deux sources distinctes pour les deux matériaux, ce qui alourdi l'appareillage.

En outre le contrôle des épaisseurs de chaque couche est délicat.

La présente invention propose de pallier les inconvénients de l'art antérieur et propose une structure de composant optique muni d'un empilement de Bragg dont les paires de couches sont composées d'un même matériau amorphe constitué d'au moins deux éléments atomiques, la variation d'indice entre les paires de couches étant obtenue par variation de la stoechiométrie desdits éléments.

L'invention concerne également le procédé de réalisation d'un tel empilement de Bragg. Ce procédé permet l'utilisation d'un unique matériau non cristallin composé d'au moins deux espèces atomiques distinctes et permet de contrôler parfaitement les variations d'indices et l'épaisseur des différentes couches successives de l'empilement de Bragg.

La présente invention a plus particulièrement pour objet un composant optique sur matériau semi-conducteur comportant au moins un empilement de Bragg comprenant une succession de couches d'indices différents, caractérisé en ce que lesdites couches sont réalisées dans un matériau amorphe composé d'au moins deux éléments prédéterminés, la différence d'indice entre les couches successives étant obtenue par des rapports stoechiométriques différents desdits éléments.

Selon une caractéristique, le matériau amorphe est constitué d'un matériau diélectrique.

Selon une autre caractéristique, les éléments prédéterminés sont constitués par du silicium (Si) et de l'azote (N) .

La présente invention concerne également un procédé de fabrication d'un composant optique sur matériau semi-conducteur comprenant au moins un empilement de Bragg, caractérisé ne ce qu'il comporte les étapes suivantes :

- réalisation d'un plasma à partir d'un premier gaz source ;
- interaction dudit plasma avec un second gaz source à la surface du substrat semi-conducteur du composant, les flux respectifs des gaz étant contrôlés de manière à obtenir une succession de couches en matériau amorphe composé de deux éléments provenant respectivement des deux gaz sources, les différentes couches présentant des rapports stoechiométriques différents.

Selon un mode de réalisation, le premier gaz source est constitué par de l'azote ($N_2$).

Selon un autre mode de réalisation, le premier gaz source est constitué par de l'ammoniac ($NH_3$).

Selon un mode de réalisation, le second gaz source est constitué par du silane ($SiH_4$).

Selon une caractéristique, le matériau amorphe est constitué de $Si_xN_yH_z$, les valeurs de x, y et z variant d'une couche à l'autre.

Selon une caractéristique, le plasma est créé dans un cylindre en soumettant le premier gaz source à une onde électromagnétique.

Selon une particularité, l'onde électromagnétique est générée par une antenne alimentée par une tension alternative à 13.56 MHz.

Préférentiellement, l'interaction entre le plasma et le second gaz source a lieu dans une chambre de confinement entourée par une pluralité d'aimants.

Le procédé selon l'invention exploite les propriétés du plasma par couplage inductif qui permet de maîtriser les incorporations des différents éléments du matériau.

Le procédé selon l'invention est en outre simple à mettre en oeuvre. Une simple variation de flux entrant de l'un ou l'autre gaz source entraînera une variation de la stoechiométrie de la couche de matériau déposée.

Le procédé selon l'invention permet donc de contrôler les épaisseurs des couches et leurs indices de réfraction respectifs.

Le procédé selon l'invention présente de nombreux avantages. En particulier, le gain de temps pour la réalisation d'un empilement de Bragg. Ainsi, pour un empilement comportant environ dix paires de couches C1, C2, le procédé selon l'invention nécessite environ 2h30 contre 8 à 10 heures d'opérations pour un procédé classique de l'art antérieur.

En outre, le procédé selon l'invention est opérationnel à faible température, soit inférieure ou égale à 180°C. Il peut donc être réalisé en fin de fabrication du composant optique sans risque de détérioration.

Dans le cas d'un empilement anti-réfléchissant, sur une photo-diode par exemple, les couches de matériau C1, C2 sont plus épaisses que celles obtenues par des procédés classiques. Néanmoins, le gain de temps et la simplicité de la mise en oeuvre demeurent.

D'autres particularités et avantages de l'invention apparaîtront à la lecture de la description qui suit, donnée à titre d'exemple illustratif et non limitatif et faite en référence aux figures annexées qui représentent :

**-** la figure 1 illustre schématiquement la structure de l'empilement de Bragg selon la présente invention ;

**-** la figure 2 illustre schématiquement l'appareillage de réalisation de l'empilement de Bragg selon l'invention ;

**-** la figure 3 est un graphe du pouvoir de réflexion en fonction de la longueur d'onde d'un empilement de Bragg selon l'invention.

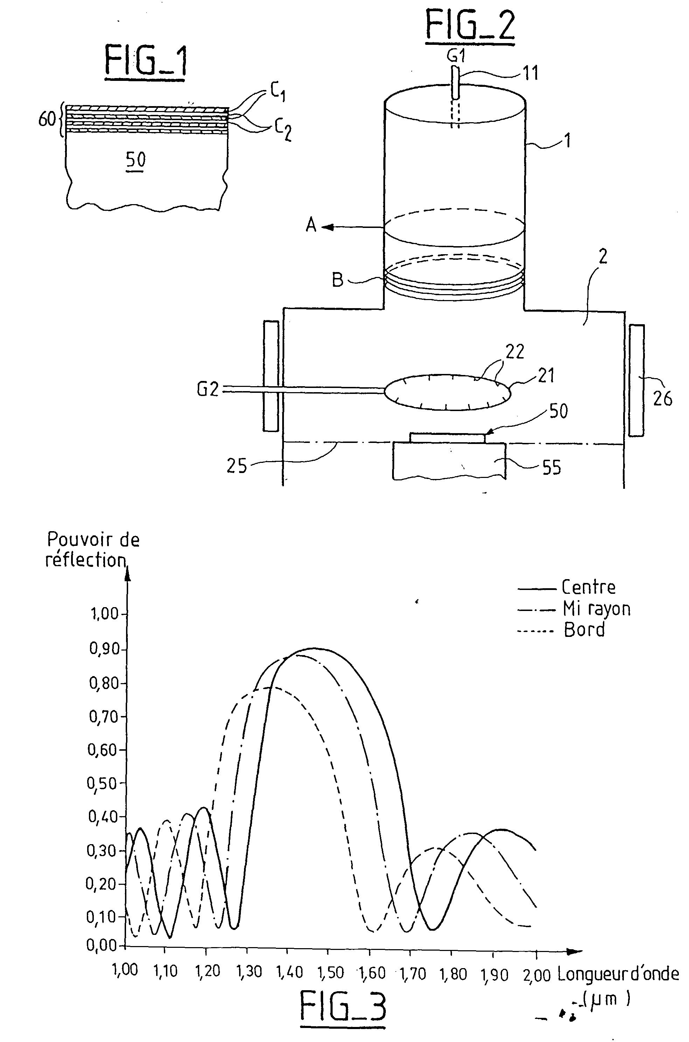

En se référant à la figure 1, un composant optoélectronique 50 présente un empilement de Bragg 60 sur sa face d'entrée. Un tel empilement se compose d'une succession de couches C1 et C2 alternées, chacune avec un indice de réfraction différent.

Selon une particularité de l'invention, les couches C1 et C2 se composent du même matériau comportant au moins deux éléments atomiques distincts.

Préférentiellement, le matériau constituant les couches C1 et C2 est un diélectrique, et les deux éléments atomiques qui composent ledit matériau sont constitués par du silicium (Si) et de l'azote (N).

On a ainsi la couche C1 constituée de $Si_{x1}N_{y1}$, et la couche C2 constituée de $Si_{x2}N_{y2}$, avec (x1,y1) et (x2,y2) les valeurs stoechiométriques des éléments Si et N des couches respectives.

En outre, l'indice de réfraction du diélectrique $Si_3N_4$ présente la particularité d'être croissant en fonction de la longueur d'onde. Ainsi, lorsque la longueur d'onde augmente, l'indice augmente également et la loi de Bragg reste vérifiée plus longtemps.

Avantageusement, la première couche de l'empilement de Bragg 60 peut constituer la passivation du composant optique 50.

L'empilement de Bragg selon l'invention est obtenu par une technique plasma, connue sous le terme générale de PECVD (Plasma Enhanced Chemical Vapor Deposition en terminologie anglaise, qui désigne une technique de dépôt chimique sous forme vapeur renforcé par un plasma).

Classiquement, le plasma est obtenu par application d'un champ électrique alternatif entre deux plaques en vis-à-vis. Le plasma est créé à partir d'un mélange de gaz provenant d'au moins deux sources différentes. Une telle technique ne permettait pas de contrôler efficacement l'épaisseur et l'indice des couches déposées.

La présente invention propose d'associer la technique générale de PECVD avec une technique connue de plasma à couplage inductif (ICP, Inductively Coupled Plasma en terminologie anglaise). Cette technique d'ICP est généralement utilisée pour de la gravure chimique sur des composants optiques.

La figure 2 illustre schématiquement l'appareillage utilisé pour réaliser un dépôt de miroir de Bragg avec une technique de PECVD/ICP.

Une telle machine se compose d'un cylindre 1, en alumine par exemple, dans lequel est introduit un premier gaz G1, source d'azote par exemple. Ce premier gaz source G1 peut être constitué par de l'Azote ($N_2$) ou de l'ammoniac ($NH_3$) par exemple. Le gaz source d'azote G1 est introduit par le haut du cylindre 1 à travers un petit conduit 11.

Le plasma est créé dans le cylindre 1 en alumine. A cette fin, le cylindre 1 est entouré d'une antenne A dans laquelle une décharge électromagnétique est envoyée. Cette décharge, d'une fréquence de 13.56 MHz par exemple, permet d'amorcer et d'entretenir le plasma à partir du gaz source d'azote G1.

Une bobine B garantit un meilleur couplage entre l'onde électromagnétique et le plasma dans le cylindre 1. On obtient ainsi un mélange de gaz neutre, d'électrons et d'ions qui se heurtent, se dissocient et se recombinent.

Une chambre de diffusion 2 se situe sous le cylindre 1. Le plasma, amorcé dans le cylindre 1 par la décharge électromagnétique, diffuse dans la chambre 2 dans laquelle le composant 50 est placé sur un support 55.

Les conditions opératoires imposent un fonctionnement sous vide dans le cylindre 1 et la chambre de diffusion 2. Un système de pompage est par conséquent prévu, tel que cela est classiquement connu de l'homme du métier.

Un second gaz source G2 est introduit dans la chambre de diffusion 2. Ce second gaz, source de silicium par exemple, est constitué par du silane ($SiH_4$) par exemple. Il est introduit à travers une couronne 21 munie de plusieurs petits orifices 22.

La chambre de diffusion 2 est préférentiellement entourée par une pluralité d'aimants 26 afin de confiner le plasma au centre de la chambre de diffusion 2, et plus particulièrement autours de la couronne 21 par laquelle le second gaz source G2 pénètre. Ce second gaz sera par conséquent fortement dissocié pour obtenir un plasma à haute densité.

La dissociation des gaz G1 et G2 peut en effet atteindre une valeur 100 fois plus élevée que celle obtenue par un plasma classique.

Une grille 25 permet avantageusement de retenir le plasma dans la chambre de diffusion 2.

Le second gaz G2, source de silicium, interagit avec le plasma du premier gaz G1, source d'azote, juste au dessus du composant 50. Les éléments atomiques des deux gaz étant fortement dissociées dans le plasma, elles se recombinent aléatoirement pour former toutes les composantes possibles de $Si_xN_yH_z$ avec des valeurs de x, y et z variant de 0 à 4.

Ces éléments interagissent à la surface du composant 50 pour former une succession de couches de $Si_xN_yH_z$ avec des valeurs de x, y, et z variables.

La présence probable d'hydrogène H dans la composition des couches C1 et C2 de l'empilement 60 n'influe pas sur les caractéristiques réfléchissantes ou anti-réfléchissante du revêtement du composant 50. La valeur non nulle de z est uniquement liée au procédé selon l'invention et au choix des gaz source G1 et G2 pour sa mise en oeuvre.

Selon le procédé de la présente invention, les flux des gaz sources G1 et G2 sont respectivement contrôlés afin de maîtriser les rapports stoechiométriques des couches successives de $Si_xN_yH_z$, ainsi que leurs épaisseurs respectives.

Un tel contrôle de stoechiométrie est possible par l'utilisation particulière de la technique ICP qui permet un taux de dissociation beaucoup plus élevé que dans les techniques classiques de PECVD.

Le graphe de la figure 3 illustre le pouvoir de réflexion d'un composant en fonction de la longueur d'onde.

Le procédé selon l'invention a été testé expérimentalement pour la réalisation d'un empilement de Bragg pour une longueur d'onde de transmission de 1.5µm, et pour des indices de réfractions respectifs de 2.413 et 1.844 des couches C1 et C2 successives. La différence d'indices pourrait être augmentée davantage selon la nature et l'épaisseur des couches réalisées.

La réflectivité a ensuite été mesurée et elle est reportée sur le graphe de la figure 3. Cette réflectivité expérimentale correspond à la valeur théorique obtenue comme suit :

$$ rf := \frac{1 - \dfrac{ns}{n1}\cdot\left(\dfrac{n2}{n3}\right)^{2.Nf}}{1 + \dfrac{ns}{n1}\cdot\left(\dfrac{n2}{n3}\right)^{2.Nf}} $$

Avec $\lambda bragg = 1.5\mu m$

ns = 3.5, indice du substrat (Si) du composant
n1 = 1, indice de l'air
n2 = 2.413, indice à $\lambda/4$ côté air
n3 = 1.844, indice à $\lambda/4$ côté substrat
Nf = 5, le nombre de paires de couches miroir.

La réflectivité, Rf, est alors :

$$ Rf = (rf)^2 = 0.92542. $$

La courbe expérimentale donne, conformément à la théorie, un empilement réfléchissant à 92.54% à la surface du composant.

### Revendications

1. Composant optique (50) sur matériau semi-conducteur comportant au moins un empilement de Bragg (60) comprenant une succession de couches (C1, C2) d'indices différents, caractérisé en ce que lesdites couches (C1, C2) sont réalisées dans un matériau amorphe composé d'au moins deux éléments prédéterminés, la différence d'indice ($n_1$, $n_2$) entre les couches successives (C1, C2) étant obtenue par des rapports stoechiométriques différents desdits éléments.

2. Composant optique selon la revendication 1, caractérisé en ce que le matériau amorphe est constitué d'un matériau diélectrique.

3. Composant optique selon la revendication 1, caractérisé en ce que les éléments prédéterminés sont constitués par du silicium (Si) et de l'azote (N).

4. Procédé de fabrication d'un composant optique (50) sur matériau semi-conducteur comprenant au moins un empilement de Bragg (60), caractérisé en ce qu'il comporte les étapes suivantes :

   - réalisation d'un plasma à partir d'un premier gaz source (G1) ;
   - interaction dudit plasma avec un second gaz source (G2) à la surface du substrat semi-conducteur du composant (50), les flux respectifs des gaz (G1, G2) étant contrôlés de manière à obtenir une succession de couches (C1, C2) en matériau amorphe composé de deux éléments provenant respectivement des deux gaz sources (G1, G2), les différentes couches (C1, C2) présentant des rapports stoechiométriques différents.

5. Procédé de fabrication selon la revendication 4, caractérisé en ce que le premier gaz source (G1) est constitué par de l'azote ($N_2$).

6. Procédé de fabrication selon la revendication 4, caractérisé en ce que le premier gaz source (G1) est constitué par de l'ammoniac ($NH_3$).

7. Procédé de fabrication selon la revendication 4, caractérisé en ce que le second gaz (G2) source est constitué par du silane ($SiH_4$).

8. Procédé de fabrication selon les revendications 4 à 7, caractérisé en ce que le matériau amorphe est constitué de $Si_xN_yH_z$, les valeurs de x, y et z variant d'une couche à l'autre.

9. Procédé de fabrication selon la revendication 4, caractérisé en ce que le plasma est créé dans un cylindre (1) en soumettant le premier gaz source (G1) à une onde électromagnétique.

10. Procédé de fabrication selon la revendication 9, caractérisé en ce que l'onde électromagnétique est générée par une antenne (A) alimentée par une tension alternative à une fréquence de 13.56 MHz.

11. Procédé de fabrication selon la revendication 4, caractérisé en ce que l'interaction entre le plasma et le second gaz source (G2) a lieu dans une chambre de confinement (2) entourée par une pluralité d'aimants (26).

FIG_1

FIG_2

Pouvoir de réflection

Centre
Mi rayon
Bord

1,00
0,90
0,80
0,70
0,60
0,50
0,40
0,30
0,20
0,10
0,00

1,00  1,10  1,20  1,30  1,40  1,50  1,60  1,70  1,80  1,90  2,00  Longueur d'onde
(μm)

FIG_3

EP 1 067 642 A1

**Office européen des brevets**

## RAPPORT DE RECHERCHE EUROPEENNE

Numéro de la demande

EP 00 40 1958

### DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| A | EP 0 676 797 A (AT & T CORP) 11 octobre 1995 (1995-10-11) * colonne 5, ligne 24-26 * * colonne 9, ligne 39-55 * * colonne 11, ligne 10-58 * --- | 1,2,4,9, 10 | H01S5/028 G02B1/10 G02B5/28 H01L31/00 |
| A | US 5 056 099 A (BRADLEY ERIC M) 8 octobre 1991 (1991-10-08) * colonne 4, ligne 24-38 * * abrégé * * colonne 5, ligne 7-18 * --- | 1,2,4 | |
| A | SCHERER A ET AL: "HIGH REFLECTIVITY DIELECTRIC MIRROR DEPOSITION BY REACTIVE MAGNETRON SPUTTERING" JOURNAL OF VACUUM SCIENCE AND TECHNOLOGY: PART A,US,AMERICAN INSTITUTE OF PHYSICS. NEW YORK, vol. 10, no. 5, 1 septembre 1992 (1992-09-01), pages 3305-3311, XP000305799 ISSN: 0734-2101 * le document en entier * --- | 1,4 | |
| A | DUDLEY J J ET AL: "TEMPERATURE DEPENDENCE OF THE PROPERTIES OF DBR MIRRORS USED IN SURFACE NORMAL OPTOELECTRONIC DEVICES" IEEE PHOTONICS TECHNOLOGY LETTERS,US,IEEE INC. NEW YORK, vol. 4, no. 4, 1 avril 1992 (1992-04-01), pages 311-314, XP000272601 ISSN: 1041-1135 * le document en entier * ----- | 1,4 | |

**DOMAINES TECHNIQUES RECHERCHES (Int.Cl.7)**

H01S

Le présent rapport a été établi pour toutes les revendications

| Lieu de la recherche | Date d'achèvement de la recherche | Examinateur |
|---|---|---|
| LA HAYE | 30 octobre 2000 | Claessen, L |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

 

& : membre de la même famille, document correspondant

EPO FORM 1503 03.82 (P04C02)

8

**ANNEXE AU RAPPORT DE RECHERCHE EUROPEENNE
RELATIF A LA DEMANDE DE BREVET EUROPEEN NO.**

EP 00 40 1958

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

30-10-2000

| Document brevet cité<br>au rapport de recherche | | Date de<br>publication | Membre(s) de la<br>famille de brevet(s) | | Date de<br>publication |
|---|---|---|---|---|---|
| EP 0676797 | A | 11-10-1995 | US | 5440575 A | 08-08-1995 |
| | | | DE | 69516933 D | 21-06-2000 |
| | | | JP | 8056056 A | 27-02-1996 |
| US 5056099 | A | 08-10-1991 | AUCUN | | |

EPO FORM P0460

Pour tout renseignement concernant cette annexe : voir Journal Officiel de l'Office européen des brevets, No.12/82